# EUROPÄISCHE PATENTSCHRIFT

(11) **EP 2 191 515 B1**
(45) Veröffentlichungstag und Bekanntmachung des Hinweises auf die Patenterteilung: **10.10.2018**
(21) Anmeldenummer: 08787170.3
(22) Anmeldetag: 13.08.2008
(51) Int. Cl.: H01L 31/055, H01L 31/0216

(54) **SOLARZELLENAUFBAU**
SOLAR CELL CONSTRUCTION
ENSEMBLE DE CELLULES SOLAIRES

(30) Priorität: 17.08.2007 EP 07114526
(43) Veröffentlichungstag der Anmeldung: 02.06.2010
(73) Patentinhaber: Heliatek GmbH, 01139 Dresden (DE)
(72) Erfinder: RENNIG, Alfred, 76833 Böchingen (DE); HAMMERMANN, Markus, 69221 Dossenheim (DE); EICKEMEYER, Felix, 68159 Mannheim (DE)
(86) Internationale Anmeldenummer: PCT/EP2008/060619
(87) Internationale Veröffentlichungsnummer: WO 2009/024509

(56) Entgegenhaltungen:
- DE-A1-102005 043 572
- JP-A- 2007 027 271
- US-A- 4 190 465
- US-A- 5 816 238
- US-A1- 2003 056 820
- D. SARTI ET AL.: "Transgformation du rayonnement solaire par fluorescence: application à l'encapsulation des cellules" SOLAR CELLS, Bd. 4, 1981, Seiten 25-35, XP002562879

## Beschreibung

### Technisches Gebiet

Die vorliegende Erfindung hat einen Solarzellenaufbau zum Gegenstand, welcher ein oder mehrere mit einem oder einer Mischung aus mehreren Fluoreszenzfarbstoffen dotierten Polymerschichten umfasst, an oder zwischen denen sich eine oder mehrere transparente Solarzellen befinden, wobei transparente Solarzellen sich dadurch auszeichnen, dass die photoaktive Schicht im Absorptionsmaximum eine Absorption von unter 80 % aufweist.

### Stand der Technik

Die Verwendung von fluoreszierenden Solarkollektoren zur Umwandlung des Sonnenspektrums in ein besser an die spektrale Empfindlichkeit von Solarzellen angepasstes Spektrum wurde bereits in den 70er Jahren beschrieben, vgl. US 4,110,123 und Weber et al., Applied Physics, 15, 1976, 2299-2300.

Einerseits kann durch Solarzellen, die eine verbesserte spektrale Empfindlichkeit aufweisen, die Energie des Sonnenlichts besser genutzt werden. In herkömmlichen Solarzellen, wie z.B. aus Silizium gefertigten Solarzellen, geht ein großer Teil der Energie in Form von Wärme verloren. Die Bandlücke kristallinen Siliziums beträgt 1,1 eV. Alle Photonen des Sonnenlichts mit einer höheren Energie können von der Solarzelle absorbiert werden, jedoch erfolgt eine Umwandlung der überschüssigen Energie in Wärme. Die Aufheizung der Solarzelle reduziert wiederum deren Wirkungsgrad. Lumineszierende Moleküle transportieren das absorbierte Sonnenspektrum bei niedrigen Energien, so dass bei geeigneter Wahl der Moleküle die Aufheizung der Solarzelle verringert wird. Anstelle der Aufheizung der Solarzelle kommt es zu einer Aufheizung derjenigen Matrix, in welche die lumineszierenden Moleküle eingebettet sind.

Andererseits kann durch den Einsatz lumineszierender Solarkollektoren die benötigte Fläche, die mit Solarzellen bestückt sein muss, reduziert werden, indem das Licht in einer Matrix, die z.B. aus Glas oder Kunststoff gefertigt wird, durch Totalreflexion an die Ränder geleitet wird. An den Rändern befinden sich die einzelnen Solarzellen. Mit dieser Ausführungsform können die Kosten des gesamten Aufbaus im Vergleich zu einer flächig aufgestellten Solarzelle erheblich herabgesetzt werden.

In der Veröffentlichung von Götzberger & Greubel, Applied Physics, 14, (1977) 123-139, sind mehrere mögliche Anordnungen von Solarzellen und Fluoreszenzkollektoren beschrieben. Es wird eine theoretisch mögliche Konversionseffizienz unter optimalen Bedingungen von 32 % angegeben, was erheblich über der Konversionseffizienz heute erhältlicher Solarzellen liegt.
Aus US 4,367,367 Reisfeld et al. sowie aus der Veröffentlichung Nature 274 (1978), Seiten 144-145, geht hervor, Uranyl-additivierte Gläser und Kombinationen mit fluoreszierenden Farbstoffen zur Verwendung als Solarkollektoren einzusetzen. Dabei absorbiert jeweils ein Farbstoff eine bestimmte Wellenlängenregion des Sonnenlichts und emittiert diese in einer anderen Wellenlängenregion, in der eine spezifische Solarzelle ihre jeweils höchste Empfindlichkeit hat. Durch einen geeigneten Aufbau aus mehreren Lagen von Farbstoffen und unterschiedlichen Solarzellen lässt sich das Sonnenspektrum der Sonne optimal nutzen.

Keiner der bisher beschriebenen lumineszierende oder fluoreszierende Systeme aufweisenden Solarkollektoren hat bis heute eine kommerzielle Nutzung, geschweige denn eine Entwicklung bis zur Serienreife erfahren, da einerseits die verwendeten organischen Farbstoffe unter Degradation im Sonnenlicht leiden, andererseits anorganische Phosphoreszenzemitter keine genügende Quantenausbeute besitzen, um die Absorptionsverluste im Solarkollektor zu überwinden.

In den letzten Jahren erfolgte jedoch die Entwicklung neuer stabiler Fluoreszenzfarbstoffe, die in Solarkollektoren eingesetzt werden könnten. Aus der Veröffentlichung Maruyama & Kitamura, Solar Energy Materials and Solar Cells 69(1), (2001), Seiten 61-68, geht hervor, wie ein Fluoreszenzfarbstoff in einem Solarkollektor, der plan auf eine CDS/CDTE-Solarzelle aufgebracht wird, die Leistung der Solarzelle um bis zu 14 % zu erhöhen vermochte. Aus der Veröffentlichung Nozik et al., Electrochemicals Soc. Proc. Vol., Band 10 (2001), Seiten 61-68, geht hervor, eine Kombination von Quantum-Dots mit Solarzellen einzusetzen. Die eingesetzten Quantum-Dots haben eine hohe Stabilität und unterliegen nicht der Photodegradation. Anderseits weisen die Quantum-Dots jedoch eine wesentlich geringere Quantenausbeute in der Matrix auf, verglichen mit Fluoreszenzfarbstoffen. Die Quantum-Dots weisen eine Quantenausbeute von ca. 50 % auf gegenüber den Fluoreszenzfarbstoffen, die eine Quantenausbeute von mehr als 90 % ausweisen. Bisher ist es nicht gelungen, Schichten mit den benötigten hohen optischen Wirkungsgraden herzustellen.

Transparente Solarzellen, so z.B. Grätzel-Zellen, organische oder anorganische Dünnschichthalbleiterzellen, sind ebenfalls bekannt.
Die Grätzel-Zelle ist aus zwei Glaselektroden mit einem Abstand von typischerweise 20 µm bis 40 µm zueinander aufgebaut. Die beiden Elektroden sind auf der Innenseite mit einer transparenten, elektrisch leitfähigen Schicht, so z.B. FTO (Fluor-dotiertes Zinndioxid SnO₂) beschichtet, welche typischerweise eine Dicke von 0,1 µm aufweist. Die beiden Elektroden werden gemäß ihrer Funktion auch Arbeitselektrode (Generierung von Elektronen) und Gegenelektrode genannt. Auf der Arbeitselektrode ist eine im Bereich von 10 µm Dicke, nanoporöse Schicht Titandioxid TiO₂ aufgebracht. Auf dessen Oberfläche wiederum ist eine Monolage eines lichtsensiblen Farbstoffs absorbiert. Auf der Gegenelektrode befindet sich eine wenige µm dicke katalytische Schicht, die meistens aus Platin gefertigt ist. Der Bereich zwischen den beiden Elektroden ist mit einem Redoxelektrolyt, z.B. einer Lösung aus Jod I₂ und Kalium-Iodid, gefüllt.
Ein weiterer Typ einer transparenten Solarzelle ist die organische p-i-n Zelle. Sie besteht aus p- und n-dotierten leitfähigen Schichten aus organischen Materialien mit großer optischer Bandlücke, die nur unwesentlich zur Absorption im sichtbaren Spektralbereich beitragen. Andererseits ist i eine undotierte photoaktive Schicht, die so dünn gehalten wird, dass sie in ihrer vollen Dicke zur Generation von Photostrom beitragen kann. Mit solchen Zellen konnten interne Quantenausbeuten von nahezu 100 % demonstriert werden.
Auch die sogenannte Tang-Zelle fällt unter die transparenten Solarzellen. Sie beruht auf der Diffusion der Excitonen zu einem Heteroübergang, an dem sie in freie Ladungsträger getrennt werden. Der begrenzende Faktor ist dabei die Excitonendiffusionslänge, die wesentlich geringer ist als die Eindringtiefe des Lichtes. Von der Gesamtdicke der Tang-Zelle von ca. 80 nm tragen damit nur ca. 10-20 nm, nämlich die unmittelbare Umgebung des Heteroübergangs, zur Generation des Photostroms bei.
Transparente Solarzellen absorbieren einen gewissen Anteil des Sonnenlichts und wandeln die Photoenergie in Strom um. Effiziente transparente Solarzellen müssen eine hohe Absorption im Spektralbereich des auftreffenden Lichtes haben. Diese hohe Extinktion kann durch Erhöhung der Dicke der photoaktiven Schicht bei allen Zellentypen erreicht werden. Eine Erhöhung der Schichtdicke senkt andererseits den Wirkungsgrad dadurch, dass die nach der Lichtabsorption erzeugten Excitonen, Elektronen und Löcher eine längere Strecke bis zu den Elektroden zurücklegen müssen und auf dem Weg zur Elektrode Rekombinationsverlusten unterliegen.

JP2007027271 und US4190465 offenbaren einen Sollarzellenaufbau mit einer Photovoltaikzelle die eine Polymerschicht umfasst, wobei die Polymerschicht mit einem fluoreszierenden Material dotiert ist.

### Offenbarung der Erfindung

Der vorliegenden Erfindung liegt die Aufgabe zugrunde, den Wirkungsgrad transparenter, das Sonnenlicht nur schwach absorbierender Solarzellen zu verbessern.
Erfindungsgemäß wird ein Solarzellenaufbau vorgeschlagen, in dem mindestens eine Photovoltaikzelle zwischen einer ersten mit einem oder einer Mischung aus mehreren fluoreszierenden Materialien dotierten Polymerschicht und einer weiteren, zweiten, ebenfalls mit einem oder einer Mischung aus mehreren fluoreszierenden Materialien versehenen angeordnet ist, wobei der als Schichtaufbau ausgebildete Solarzellenaufbau eine erste verspiegelte Kante und eine zweite verspiegelte Kante sowie auch verspiegelte vordere und hintere Kanten aufweist und wobei das eine fluoreszierende Material oder die Mischung aus mehreren fluoreszierenden Materialien organische Fluoreszenzfarbstoffe enthalten oder anorganische Phosphoreszenzemitter umfassen.
Die Fluoreszenzfarbstoffe werden so ausgewählt, dass sie einen möglichst großen Anteil des Sonnenlichtes absorbieren und in die Absorptionsbande der photoaktiven Schicht der transparenten Solarzelle emittieren. In einer vorteilhaften Ausführungsform kann an der Oberseite der obersten Schicht des erfindungsgemäß vorgeschlagenen Solarzellenaufbaus ein Bandpassfilter angebracht werden.
Das in der mindestens einen dotierten Polymerschicht erzeugte Fluoreszenzlicht durchstrahlt die mindestens eine zwischen den Schichten befindliche, dort angeordnete Photovoltaikzelle und durchläuft die Photovoltaikzelle mehrfach. Die zwischen den Schichten befindlichen Solarzellen absorbieren in vorteilhafter Weise ohne die Polymerschicht bereits einen gewissen Anteil des auftreffenden Sonnenlichts und wandeln diesen in Strom um. Durch die mehrfache Durchstrahlung der transparenten Solarzellen, die zwischen, über oder unter den dotierten Polymerschichten angeordnet sind, kann ein wesentlich höherer Anteil des Sonnenlichts absorbiert und in elektrischen Strom umgewandelt werden. Außerdem wird durch den flachen Durchstrahlwinkel des Fluoreszenzlichtes durch die Solarzelle die Absorptionswahrscheinlichkeit erhöht. Die Anzahl der Durchstrahlungen der Funktionsschicht wird durch eine möglichst geringe Dicke des Schichtaufbaus gesteigert.

Der erfindungsgemäß vorgeschlagene Solarzellenaufbau umfasst eine oder mehrere Solarzellen, die nur eine geringe Absorption, die zwischen 0 - 0,5 liegt, und eine nur sehr geringe Schichtdicke 10 nm - 300 nm der photoaktiven Schicht besitzen und sich durch geringere Rekombinationsverluste auszeichnen.

Die seitlichen Kanten des Solarzellenaufbaus können in vorteilhafter Weise verschieden ausgebildet werden. Um das außerhalb eines Totalreflexionswinkels emittierte Licht (Größenordnung ca. 20 %) im Schichtaufbau zu führen, kann optional eine selektiv reflektierende Bandpassfilterschicht an der Oberseite auf den erfindungsgemäß vorgeschlagenen Solarzellenaufbau aufgebracht werden, an der das Licht auftrifft, d.h. an der Beleuchtungsseite. Unterhalb des geschichtet ausgebildeten Solarzellenaufbaus kann transmittiertes Licht über einen Reflektor in den Solarzellenaufbau zurückreflektiert werden. Als Fluoreszenzfarbstoffe zur Dotierung der Polymerschichten können in einer bevorzugten Ausführungsform Perylene oder andere photostabile Farbstoffe verwendet werden, die eine möglichst hohe Quantenausbeute besitzen. Weiterhin eignen sich Quantum-Dots oder phosphoreszierende anorganische seltene Erdverbindungen.

In einer besonders bevorzugten Ausführungsform des erfindungsgemäß vorgeschlagenen Solarzellenaufbaus können die dotierten Polymerschichten als polymere Fluoreszenzkollektorplatten aus Polymethylmethacrylat (PMMA) bzw. Polylaurylmethacrylat (PLMA) gefertigt werden. Die Konzentration der hier eingesetzten Fluoreszenzfarbstoffe wird so eingestellt, dass die Extinktion über die Schichtdicke der Schichten über einen möglichst breiten Spektralbereich nahe bei 1 liegt. In einer besonders bevorzugten Ausführungsform der Erfindung liegen die Farbstoffkonzentrationen für die einen oder mehreren organischen oder anorganischen Fluoreszenzfarbstoffe zur Dotierung der Polymerschicht in der Größenordnung zwischen 20 ppm und 100 ppm. Die Schichtdicke der Polymerschicht sollte möglichst klein und bevorzugt im Bereich 0,1 bis 1mm gewählt werden, um eine häufige Durchstrahlung der photoaktiven Schicht zu gewährleisten.

### Kurze Beschreibung der Zeichnungen

Anhand der Zeichnung wird die Erfindung nachstehend eingehender beschrieben.

Es zeigt:
- Figur 1: eine nicht erfindungsgemäße Ausführungsform eines Solarzellenaufbaus
- Figur 2: die Darstellung eines Schichtaufbaus des erfindungsgemäß vorgeschlagenen Solarzellenaufbaus.

### Ausführungsformen

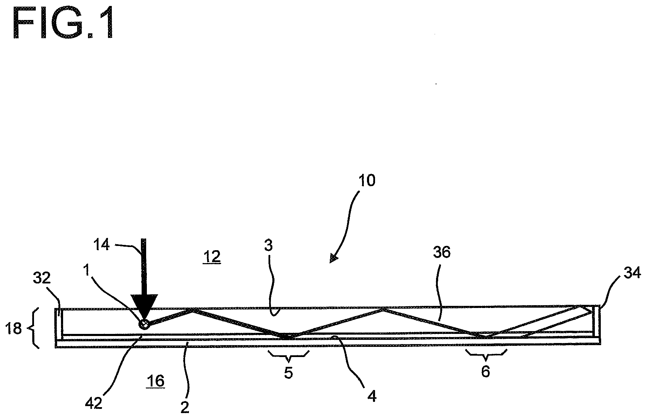

Der Darstellung gemäß Figur 1 ist eine Ausführungsvariante eines nichterfindungsgemäßen Solarzellenaufbaus zu entnehmen.

Figur 1 zeigt einen Solarzellenaufbau 10, der eine Polymerschicht 36 umfasst. Unterhalb der Polymerschicht 36 befindet sich eine Photovoltaikzelle 42, unter der wiederum eine Spiegelfläche 2 angeordnet sein kann. Bezugszeichen 14 bezeichnet auf einer Beleuchtungsseite 12 einfallendes Licht, welches auf in einer Polymerschicht 36 "gelöste" Farbfluoreszenzmoleküle 1 trifft. Von diesen wird das einfallende Licht 14 in einer stochachstischen Verteilung in alle möglichen denkbaren Raumrichtungen wellenlängenverschoben emittiert. Von diesem emittierten Licht interessiert für die nachfolgenden Betrachtungen lediglich der Teil, der infolge der Totalreflexion an einer ersten Reflexionsfläche 3 der Polymerschicht 36 an eine zweite Reflexionsfläche 4, d.h. die Oberseite der Spiegelfläche 2, reflektiert wird. Der in Figur 1 dargestellte Solarzellenaufbau 10 - als Schichtaufbau 18 ausgeführt - umfasst neben der Polymerschicht 36 die sehr dünn ausgebildete Photovoltaikzelle 42, unterhalb der sich die bereits erwähnte Spiegelfläche 2 befindet. Der Solarzellenaufbau ist an seinen Rändern mit verspiegelten Kanten 32 und 34 versehen. Auch die nicht dargestellten Vorder- und Rückseitenkanten sind verspiegelt. Dies verhindert - wie in Figur 1 angedeutet -, dass das Fluoreszenzlicht seitlich aus dem Schichtaufbau 18, insbesondere aus der Polymerschicht 36 austritt. Aufgrund der Reflexion des zunächst vom Fluoreszenzfarbstoffmolekül 1 emittierten Anteil des einfallenden Lichts 14 an die erste Reflexionsfläche 3, stellt sich nach Ablenkung des Strahls ein erster Lichtdurchlauf 5 durch die Photovoltaikzelle 42 ein.

Aufgrund der Reflexion an der zweiten Reflexionsfläche 4, d.h. der Spiegelfläche 2, folgt ein weiterer, zweiter Lichtdurchlauf 6 durch die Photovoltaikzelle 42 sowie eine Reflexion des Lichts an der Innenseite der zweiten verspiegelt ausgebildeten Kante 34. Von dieser her tritt das reflektierte Licht erneut in die Photovoltaikzelle 42, d.h. hier von der Oberseite aus, ein.

Der Anteil des einfallenden Lichts 14, welches unter einem Winkel größer des Grenzwinkels der Totalreflexion emittiert wird, durchläuft mehrmals die Photovoltaikzelle 42. Wie aus der Darstellung gemäß Figur 1 hervorgeht, umfasst der erfindungsgemäße Solarzellenaufbau 10 mindestens eine fluoreszente Schicht in Gestalt der Polymerschicht 36. In dieser sind Fluoreszenzfarbstoffmoleküle, vgl. Bezugszeichen 1 in Fig. 1, gelöst. Abweichend von einer gleichmäßigen Verteilung der Fluoreszenzfarbstoffmoleküle 1 innerhalb der Polymerschicht 36 können in dieser auch fluoreszente Nanopartikel, so genannte Quantum Dots, feindispergiert eingelagert sein, die die Funktion der Fluoreszenzfarbstoffmoleküle übernehmen.

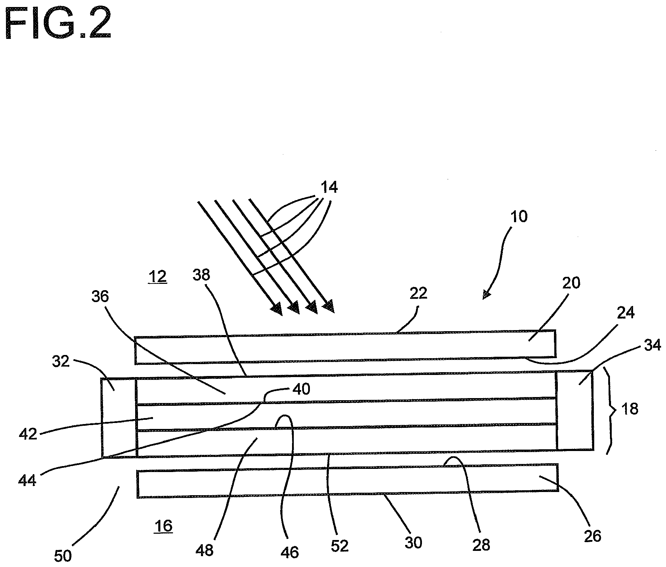

In seiner in Figur 1 dargestellten einfachsten Ausführungsform umfasst der Solarzellenaufbau 10 neben der Polymerschicht 36 und der Photovoltaikzelle 42 die als Reflektor dienende Spiegelfläche 2. In diesem Falle umfasst ein Schichtaufbau 1 die genannten Komponenten 2, 36 sowie 42. Wie nachfolgend, insbesondere in Zusammenhang mit der Darstellung gemäß Figur 2, noch dargelegt werden wird, kann der Solarzellenaufbau 10 auch mehr Schichten als die in Figur 1 dargestellten Schichten aufweisen.

Durch die Verspiegelung der Kanten, wie in der Darstellung gemäß Figur 1 durch die Bezugszeichen 32 und 34 angedeutet, kann erreicht werden, dass die Anzahl der Lichtdurchläufe 5, 6, die in Figur 1 lediglich angedeutet sind, gesteigert wird, indem die Lichtstrahlen des emittierten Lichts 37 an einem seitlichen Austritt aus der Polymerschicht 36, eben aufgrund der verspiegelten ersten und zweiten Kante 32 bzw. 34, gehindert werden.

In der Darstellung gemäß Figur 1 umfasst der Schichtaufbau 18 des Solarzellenaufbaus 10 die Spiegelfläche 2. Im Zusammenhang mit dem Solarzellenaufbau 10 in der Ausführungsform gemäß Figur 1 sind die Fluoreszenzfarbstoffmoleküle 1 in Form kleinster Partikel in der Polymerschicht 36 gelöst. Die Fluoreszenzfarbstoffe bzw. die Quantum Dots könnten auch in die Funktionsschichten (n, p Leiter, Elektrolyt etc.) der Photovoltaikzelle 42 eingebracht sein. Dabei kann die Schicht 36 entfallen.

Der Darstellung gemäß Figur 2 ist eine Ausführungsform des erfindungsgemäß vorgeschlagenen, in Stapelform ausgebildeten Solarzellenaufbaus zu entnehmen.

Figur 2 zeigt, dass ein erfindungsgemäß vorgeschlagener Solarzellenaufbau 10 von einer Beleuchtungsseite 12 her mit Licht 14 bestrahlt wird. Der Solarzellenaufbau 10 gemäß der Darstellung in Figur 2 ist im Wesentlichen als ein Schichtaufbau 18 ausgebildet. Während auf der Beleuchtungsseite 12 Licht 14 in den Solarzellenaufbau 10 einfällt, unterbleibt dies auf der der Beleuchtungsseite 12 gegenüberliegenden Seite 16. Optional kann auf der Beleuchtungsseite 12 des erfindungsgemäß vorgeschlagenen, in Figur 2 schematisch dargestellten Solarzellenaufbaus 10 ein Bandpassfilter 20 vorgesehen sein. Der Bandpassfilter 20 dient dazu, das außerhalb des Totalreflexionswinkels emittierte Licht in den Solarzellenaufbau 10 zu führen. Während auf der Beleuchtungsseite 12 des Solarzellenaufbaus 10 gemäß der Darstellung in Figur 2 der Bandpassfilter 20 angeordnet sein kann, kann auf der gegenüberliegenden Seite 16 ein Reflektor 26 vorgesehen sein. Der Reflektor 26 hat die Aufgabe, das transmittierte Licht in den Solarzellenaufbau zurückzureflektieren. Der Bandpassfilter 20 umfasst eine durch Bezugszeichen 22 identifizierte erste Seite und eine weitere, zweite Seite 24, die einer ersten Seite 38 einer ersten Polymerschicht 36 zuweist. Die erste Polymerschicht 36 ist Teil des Schichtaufbaus 18. Zwischen der ersten Polymerschicht 36 und mindestens einer weiteren, zweiten Polymerschicht 48 befindet sich eine Photovoltaikzelle 42. Bei der Voltaikzelle 42 handelt es sich um eine transparente Solarzelle, die durch eine beliebige transparente Solarzelle dargestellt sein kann.

Aus der Darstellung gemäß Figur 2 geht hervor, dass der Schichtaufbau 18 eine erste verspiegelte Kante 32 und eine zweite verspiegelte Kante 34 aufweist. Auch die nicht dargestellten Vorder- und Rückseitenkanten sind verspiegelt. Der Schichtaufbau 18 gemäß der Darstellung in Figur 2 umfasst demnach die erste Polymerschicht 36, auf deren erster Seite 38 optional der Bandpassfilter 20 mit seiner zweiten Seite 24 aufgebracht werden kann, die mindestens eine Photovoltaikzelle 42, die zwischen einer zweiten Seite 40 der ersten Polymerschicht 36 und einer ersten Seite 54 der zweiten Polymerschicht 48 liegt. Optional kann der zweiten Seite 52 der zweiten Polymerschicht 48 der Reflektor 26 zu erneuten Reflexion des transmittierten Lichtes in den Solarzellenaufbau 10 zugeordnet sein.

Der erfindungsgemäß vorgeschlagene Solarzellenaufbau 10 zeichnet sich dadurch aus, dass die erste bzw. die zweite Polymerschicht 36 bzw. 48 mit einem oder mehreren anorganischen oder organischen Fluoreszenzfarbstoffen oder anderen fluoreszierenden Materialien dotiert sind. Unter Dotierung der ersten Polymerschicht 36 bzw. der zweiten Polymerschicht 38 ist im vorliegenden Zusammenhang zu verstehen, dass in das Polymermaterial, aus dem die erste Polymerschicht 36 bzw. die zweite Polymerschicht 38 gefertigt sind, fluoreszierende Moleküle oder Nanoteilchen (Quantum Dots) eingebracht sind. Als Material zur Herstellung der ersten Polymerschicht 36 bzw. der zweiten Polymerschicht 38 werden bevorzugt Polymethylmethacrylat (PMMA) bzw. Polylaurylmethacrylat (PLMA) eingesetzt. Bei der Dotierung der ersten Polymerschicht 36 bzw. der zweiten Polymerschicht 38 wird die Konzentration der verwendeten Fluoreszenzfarbstoffe bzw. die Konzentration eines Fluoreszenzfarbstoffe enthaltenden Gemisches mehrerer fluoreszierender Materialien so eingestellt, dass die Transmission über die Schichtdicke der Schichten über einen möglichst breiten Spektralbereich des Sonnenlichts nahe 10 % ist. In vorteilhafter Weise wird die Farbstoffkonzentration der anorganischen oder organischen Fluoreszenzfarbstoffe bzw. des Gemisches verwendeter fluoreszierender Materialien zwischen 20 ppm und 100 ppm eingestellt.

Als Fluoreszenzfarbstoffe zur Dotierung der ersten Polymerschicht 36 bzw. der zweiten Polymerschicht 38 können u.a. auch Perylene oder andere photostabile Farbstoffe verwendet werden, die eine möglichst hohe Quantenausbeute besitzen. Des Weiteren kann zur Dotierung der ersten Polymerschicht 36 bzw. der zweiten Polymerschicht 38 auch Quantum-Dots oder phosphoreszierende anorganische seltene Erdverbindungen eingesetzt werden.

Der erfindungsgemäß vorgeschlagene Solarzellenaufbau 10 absorbiert einen Anteil des Sonnenlichts und wandelt die Photonenenergie in elektrische Energie um. Der Solarzellenaufbau 10 weist im Gegensatz zur transparenten Solarzelle eine hohe Absorption im Spektralbereich des auftreffenden Lichts auf. Dies wird dadurch erreicht, dass die fluoreszierenden Schichten 36 und 48 Licht absorbieren und durch Totalreflexion im Solarzellenaufbau 10 führen. Dabei wird das geführte Licht bei jedem Durchlauf durch die photoaktive Schicht der transparenten Solarzelle 42 zum Teil absorbiert und in elektrische Energie gewandelt. Eine Erhöhung der Schichtdicke und damit der Absorption der photoaktiven Schicht der transparenten Solarzelle würde zu längeren Wegen der Excitonen, Elektronen und Löchern in der transparenten Solarzelle führen. Längere Wege verringern aber wegen der erhöhten Rekombinationswahrscheinlichkeit der nach der Lichtabsorption erzeugten Elektronen-Loch-Paare den erreichbaren Wirkungsgrad.

### Bezugszeichenliste

- 1: Fluoreszenzfarbstoffmolekül
- 2: Spiegelfläche, AI, Ag, Au
- 3: erste Reflexionsfläche
- 4: zweite Reflexionsfläche
- 5: erster Lichtdurchlauf
- 6: zweiter Lichtdurchlauf
- 7:
- 8:
- 9:
- 10: Solarzellenaufbau
- 12: Beleuchtungsseite
- 14: einfallendes Licht
- 16: gegenüberliegende Seite
- 18: Schichtaufbau
- 20: Bandpassfilter
- 22: erste Seite Bandpassfilter
- 24: zweite Seite Bandpassfilter
- 26: diffuser Reflektor
- 28: erste Seite diffuser Reflektor
- 30: zweite Seite diffuser Reflektor
- 32: erste verspiegelte Kante
- 34: zweite verspiegelte Kante
- 36: erste Polymerschicht
- 38: erste Seite erste Polymerschicht
- 40: zweite Seite erste Polymerschicht
- 42: Photovoltaikzelle
- 44: erste Seite
- 46: zweite Seite
- 48: zweite Polymerschicht
- 50: erste Seite zweite Polymerschicht
- 52: zweite Seite zweite Polymerschicht

## Patentansprüche

1. Solarzellenaufbau (10) mit mindestens einer transparenten Photovoltaikzelle (42) insbesondere einer Farbstoffsolarzelle oder einer Dünnschichthalbleiterzelle, wobei eine photoaktive Schicht der Photovoltaikzelle (42) im Absorptionsmaximum eine Absorption von unter 80% aufweist, **dadurch gekennzeichnet, dass** der Solarzellenaufbau (10) im Wesentlichen als Schichtaufbau (18) ausgebildet ist, in dem mindestens eine Photovoltaikzelle (42) zwischen einer ersten mit einem oder einer Mischung aus mehreren fluoreszierenden Materialien dotierten Polymerschicht (36) und einer weiteren, zweiten, ebenfalls mit einem oder einer Mischung aus mehreren fluoreszierenden Materialien versehenen Polymerschicht (48) angeordnet ist wobei die dotierte erste Polymerschicht (36) die mindestens eine transparente Photovoltaikzelle (42) überdeckt, wobei der als Schichtaufbau (18) ausgebildete Solarzellenaufbau (10) eine erste verspiegelte Kante (32) und eine zweite verspiegelte Kante (34) sowie auch verspiegelte vordere und hintere Kanten aufweist und wobei das eine fluoreszierende Material oder die Mischung aus mehreren fluoreszierenden Materialien organische Fluoreszenzfarbstoffe enthalten oder anorganische Phosphoreszenzemitter umfassen.

2. Solarzellenaufbau (10) gemäß Anspruch 1, **dadurch gekennzeichnet, dass** das eine fluoreszierende Material Quantum-Dots enthält.

3. Solarzellenaufbau (10) gemäß Anspruch 1, **dadurch gekennzeichnet, dass** die mindestens eine Polymerschicht (36, 48) aus einem Material aus der nachfolgenden Aufzählung ausgewählt ist: Polyacrylate, Polymethylmethacrylat (PMMA), Polylaurylmethacrylat (PLMA) oder Polymere.

4. Solarzellenaufbau (10) gemäß Anspruch 1, **dadurch gekennzeichnet, dass** die mindestens eine Polymerschicht (36, 48) aus Polycarbonat gefertigt ist.

5. Solarzellenaufbau (10) gemäß Anspruch 1, **dadurch gekennzeichnet, dass** die bevorzugt transparent ausgebildete mindestens eine Photovoltaikzelle (42) eine Farbstoffsolarzelle nach dem Grätzel-Typ darstellt, als Dünnschichthalbleiterzelle ausgebildet ist oder eine organische Solarzelle ist.

6. Solarzellenaufbau (10) gemäß Anspruch 1, **dadurch gekennzeichnet, dass** die fluoreszierenden Materialien in einer Konzentration von 1 ppm bis 500 ppm, bevorzugt zwischen 20 ppm bis 200 ppm, in die mindestens eine Polymerschicht (36, 48) eingebracht werden.

7. Solarzellenaufbau (10) gemäß Anspruch 1, **dadurch gekennzeichnet, dass** unterhalb einer Polymerschicht (36, 48) eine Spiegelfläche (2, 26) angeordnet ist.

8. Solarzellenaufbau (10) gemäß Anspruch 1, **dadurch gekennzeichnet, dass** auf einer Beleuchtungsseite (12) des Solarzellenaufbaus (10) an einer ersten Seite (38) einer ersten mit fluoreszierendem Material versehenen ersten Polymerschicht (36) ein Bandpassfilter (20) angeordnet ist.

9. Solarzellenaufbau (10) gemäß einem oder mehrerer der vorgehenden Ansprüche, **dadurch gekennzeichnet, dass** als fluoreszierende Materialien Perylene oder andere photostabile Farbstoffe eingesetzt werden, die eine hohe Quantenausbeute aufweisen.

10. Solarzellenaufbau (10) gemäß einem oder mehrerer der vorgehenden Ansprüche, **dadurch gekennzeichnet, dass** als fluoreszierende Materialien phosphoreszierende anorganische seltene Erdverbindungen zur Dotierung der Polymerschichten (36, 48) verwendet werden.

11. Solarzellenaufbau (10) gemäß einem oder mehrerer der vorgehenden Ansprüche, **dadurch gekennzeichnet, dass** die Konzentration der zur Dotierung der mindestens zwei Polymerschichten (36, 48) eingesetzten fluoreszierenden Materialien so eingestellt wird, dass die Transmission über die Schichtdicke der mindestens zwei Polymerschichten (36, 48) über einen möglichst breiten Spektralbereich kleiner 10 % ist.

12. Solarzellenaufbau gemäß einem oder mehrerer der vorgehenden Ansprüche, **dadurch gekennzeichnet, dass** eine oder mehrere Funktionsschichten der transparenten Photovoltaik-Zelle zum Beispiel n, p Leiter mit fluoreszierenden Molekülen oder Nanopartikeln dotiert sind.

## Claims

1. Solar cell structure (10) having at least one transparent photovoltaic cell (42), in particular a dye solar cell or a thin-film semiconductor cell, where a photoactive layer of the photovoltaic cell (42) has an absorption of less than 80% at the absorption maximum, **characterized in that** the solar cell structure (10) is designed essentially as a layer structure (18) in which at least one photovoltaic cell (42) is arranged between a first polymer layer (36) doped with one or a mixture of a plurality of fluorescent materials and a further, second polymer layer (48) likewise provided with one or a mixture of a plurality of fluorescent materials, where the doped first polymer layer (36) covers the at least one transparent photovoltaic cell (42), where the solar cell structure (10) designed as a layer structure (18) has a first mirrored edge (32) and a second mirrored edge (34) as well as likewise mirrored front and rear edges, and where the one fluorescent material or the mixture of a plurality of fluorescent materials contains organic fluorescent dyes or contains inorganic phosphorescent emitters.

2. Solar cell structure (10) according to Claim 1, **characterized in that** the one fluorescent material contains quantum dots.

3. Solar cell structure (10) according to Claim 1, **characterized in that** the at least one polymer layer (36, 48) is made from a material selected from the following list: polyacrylates, polymethyl methacrylate (PMMA), polylauryl methacrylate (PLMA) or polymers.

4. Solar cell structure (10) according to Claim 1, **characterized in that** the at least one polymer layer (36, 48) is made from polycarbonate.

5. Solar cell structure (10) according to Claim 1, **characterized in that** the preferably transparently designed at least one photovoltaic cell (42) constitutes a dye solar cell according to the Grätzel type, is designed as a thin-film semiconductor cell or is an organic solar cell.

6. Solar cell structure (10) according to Claim 1, **characterized in that** the fluorescent materials are introduced into the at least one polymer layer (36, 48) with a concentration of from 1 ppm to 500 ppm, preferably between 20 ppm and 200 ppm.

7. Solar cell structure (10) according to Claim 1, **characterized in that** a mirror surface (2, 26) is arranged below a polymer layer (36, 48).

8. Solar cell structure (10) according to Claim 1, **characterized in that** a bandpass filter (20) is arranged on an illumination side (12) of the solar cell structure (10), on a first side (38) of a first polymer layer (36) provided with a first fluorescent material.

9. Solar cell structure (10) according to one or more of the preceding claims, **characterized in that** perylenes or other photostable dyes, which have a high quantum efficiency, are used as fluorescent materials.

10. Solar cell structure (10) according to one or more of the preceding claims, **characterized in that** phosphorescent inorganic rare-earth compounds are used as fluorescent materials for doping the polymer layers (36, 48).

11. Solar cell structure (10) according to one or more of the preceding claims, **characterized in that** the concentration of the fluorescent materials used for doping the at least two polymer layers (36, 48) is adjusted so that the transmission over the layer thickness of the at least two polymer layers (36, 48) is less than 10% over as wide a spectral range as possible.

12. Solar cell structure according to one or more of the preceding claims, **characterized in that** one or more functional layers of the transparent photovoltaic cell, for example n, p conductors, are doped with fluorescent molecules or nanoparticles.

## Revendications

1. Ensemble de cellules solaires (10) avec au moins une cellule photovoltaïque transparente (42), en particulier une cellule solaire à pigment photosensible ou une cellule à semi-conducteur à couche mince, dans lequel une couche photoactive de la cellule photovoltaïque (42) présente au maximum d'absorption une absorption de moins de 80 %, **caractérisé en ce que** l'ensemble de cellules solaires (10) est réalisé essentiellement comme ensemble stratifié (18), dans lequel au moins une cellule photovoltaïque (42) est disposée entre une première couche polymère (36) dopée avec une ou un mélange de plusieurs matières fluorescentes et une autre deuxième couche polymère (48) également munie d'une ou d'un mélange de plusieurs matières fluorescentes, dans lequel la première couche polymère dopée (36) recouvre ladite au moins une cellule photovoltaïque transparente (42), dans lequel l'ensemble de cellules solaires (10) réalisé comme ensemble stratifié (18) présente un premier côté métallisé (32) et un second côté métallisé (34) ainsi que des côtés avant et arrière également métallisés et dans lequel ladite une matière fluorescente ou le mélange de plusieurs matières fluorescentes contient des colorants fluorescents organiques ou comprend des émetteurs phosphorescents inorganiques.

2. Ensemble de cellules solaires (10) selon la revendication 1, **caractérisé en ce que** ladite une matière fluorescente contient des boîtes quantiques.

3. Ensemble de cellules solaires (10) selon la revendication 1, **caractérisé en ce que** ladite au moins une couche polymère (36, 48) est choisie parmi un matériau de la liste suivante: polyacrylate, polyméthacrylate de méthyle (PMMA), polyméthacrylate de lauryle (PLMA) ou polymères.

4. Ensemble de cellules solaires (10) selon la revendication 1, **caractérisé en ce que** ladite au moins une couche polymère (36, 48) est fabriquée en polycarbonate.

5. Ensemble de cellules solaires (10) selon la revendication 1, **caractérisé en ce que** ladite au moins une cellule photovoltaïque de préférence transparente (42) représente une cellule solaire à pigment photosensible du type Grätzel, est formée par une cellule à semi-conducteur à couche mince ou est une cellule solaire organique.

6. Ensemble de cellules solaires (10) selon la revendication 1, **caractérisé en ce que** les matériaux fluorescents sont introduits dans ladite au moins une couche polymère (36, 48) en une concentration de 1 ppm à 500 ppm, de préférence entre 20 ppm à 200 ppm.

7. Ensemble de cellules solaires (10) selon la revendication 1, **caractérisé en ce qu'**une face réfléchissante (2, 26) est disposée en dessous d'une couche polymère (36, 48).

8. Ensemble de cellules solaires (10) selon la revendication 1, **caractérisé en ce qu'**un filtre passe-bande (20) est disposé sur un côté d'éclairage (12) de l'ensemble de cellules solaires (10) sur un premier côté (38) d'une première couche polymère (36) munie d'une matière fluorescente.

9. Ensemble de cellules solaires (10) selon une ou plusieurs des revendications précédentes, **caractérisé en ce que** l'on utilise comme matière fluorescente des pérylènes ou d'autres colorants photostables, qui présentent un rendement quantique élevé.

10. Ensemble de cellules solaires (10) selon une ou plusieurs des revendications précédentes, **caractérisé en ce que** l'on utilise comme matières fluorescentes des composés de terres rares inorganiques phosphorescents pour le dopage des couches polymères (36, 48).

11. Ensemble de cellules solaires (10) selon une ou plusieurs des revendications précédentes, **caractérisé en ce que** la concentration des matières fluorescentes utilisées pour le dopage desdites au moins deux couches polymères (36, 48) est réglée de telle manière que la transmission sur l'épaisseur de couche desdites au moins deux couches polymères (36, 48) sur un domaine spectral aussi large que possible soit inférieure à 10 %.

12. Ensemble de cellules solaires selon une ou plusieurs des revendications précédentes, **caractérisé en ce qu'**une ou plusieurs couche(s) fonctionnelle(s) de la cellule photovoltaïque transparente par exemple des conducteurs n, p sont dopées avec des molécules ou des nanoparticules fluorescentes.
